# FASCICULE DE BREVET EUROPEEN

(11) **EP 1 069 679 B1**
(45) Date de publication et mention de la délivrance du brevet: **19.10.2005**
(21) Numéro de dépôt: 00401975.8
(22) Date de dépôt: 07.07.2000
(51) Int. Cl.: H03G 11/02

(54) **Limiteur de puissance faible cout**
Kostengünstiger Begrenzer für hohe Leistungen
Low Cost Power Limiter

(30) Priorité: 16.07.1999 FR 9909276
(43) Date de publication de la demande: 17.01.2001
(73) Titulaire: Thales, 75008 Paris (FR)
(72) Inventeur: Tolant, Clément, Thomson-CSF Propriété Intellect., 94117 Arcueil Cédesx (FR); Eudeline, Philippe, Thomson-CSF Propriété Intell., 94117 Arcueuil Cédex (FR); Pavaut, Stéphane, Thomson-CSF Propriété Intellect., 94117 Arcueil Cédex (FR)
(74) Mandataire: Lucas, Laurent Jacques

(56) Documents cités:
- US-A- 4 232 278
- US-A- 4 635 297
- US-A- 5 128 636
- PATENT ABSTRACTS OF JAPAN vol. 1999, no. 12, 29 octobre 1999 (1999-10-29) & JP 11 195944 A (NEW JAPAN RADIO CO LTD), 21 juillet 1999 (1999-07-21)

## Description

La présente invention concerne un limiteur de puissance hyperfréquence à faible coût comportant des diodes P.I.N. Elle s'applique notamment à la limitation de puissance en bande S.

Le limiteur de l'invention est de type actif, il est notamment utilisé dans les modules Emission/Réception état solide de radars pour protéger la partie sensible du récepteur contre des signaux de puissances trop élevées.

Alors qu'une voie émission de radar classique peut véhiculer des signaux de très forte puissance, par exemple de l'ordre de quelques kilowatts de puissance crête, la voie de réception ne traite en revanche que des signaux de très faible niveau, par exemple au maximum de quelques milliwatts. En limite de détection du radar, la puissance réémise par une cible et détectée par le radar est très faible. Il est donc important que les composants de la chaîne de réception, et notamment les amplificateurs, présentent eux-mêmes un bon facteur de bruit afin de ne pas dégrader la dynamique du système. En contrepartie ces composants ne supportent généralement pas des niveaux de puissance élevés, même transitoires et offrent un seuil de vulnérabilité proche de 20 dBm. Il est donc nécessaire de prévoir des dispositifs de limitation de puissance dans les voies de réception pour s'affranchir des différentes menaces.

Le module émission-réception comporte généralement un duplexeur de puissance chargé d'assurer l'aiguillage entre les différentes voies. C'est un élément à trois ports, laissant passer les signaux de la chaîne d'émission vers l'antenne et véhiculant les signaux reçus de l'antenne vers la chaîne de réception. Bien qu'adapté dans la bande de fréquence utile, le duplexeur ne présente pas une isolation parfaite, c'est-à-dire qu'une partie du signal émis se trouve par exemple sur la voie de réception. Cette fuite de puissance résiduelle est généralement accompagnée par des signaux d'amplitude plus élevée issus de la désadaptation de l'élément rayonnant. Ces deux effets conjugués représentent la menace interne pour le récepteur. La menace externe est causée par exemple par la présence de brouilleurs, de signaux dus à des radars proches ou encore à des échos forts provenant de cibles fixes.

Les émetteurs radar dits à état solide regroupent généralement un nombre élevé de transistors de puissance. Cette technologie est notamment utilisée pour réduire les coûts tout en améliorant la fiabilité du système. Ce type d'émission est présent notamment dans les antennes réparties ou semi-réparties, où on la retrouve associée à des chaînes de réception comportant des limiteurs moyenne puissance très compacts de type actif ou passif.

Un limiteur passif comporte une ou plusieurs diodes de limitation de type P.I.N. placées en parallèle sur une ligne de propagation. La tenue en puissance de ces limiteurs passifs est faible car la résistance équivalente des diodes P.I.N. en régime de conduction n'atteint pas sa valeur minimale. Cet effet se traduit par un échauffement des diodes placées sur l'étage de puissance c'est-à-dire en entrée du limiteur.

Les limiteurs actifs permettent de s'affranchir de cet inconvénient et d'avoir notamment des tenues en puissance plus élevées. Leur principe repose sur l'injection d'un courant de polarisation dans la ou les diodes P.I.N. de l'étage de puissance afin d'amener leur résistance équivalente à un niveau minimal. Parmi les principales architectures de limiteurs actifs, nous trouvons les structures absorptives et réflexives.

Les structures absorptives comportent un circuit auxiliaire avec une diode de commutation associée à une charge 50 ohms de puissance qui absorbe l'énergie réfléchie par les diodes P.I.N. de puissance quand elles entrent en régime de conduction. Ces structures absorptives présentent des pertes d'insertion bas niveau élevées, elles sont donc rarement utilisées pour les applications radar.

Les structures réflexives dans lesquelles l'énergie incidente est réfléchie en entrée sont beaucoup plus utilisées et notamment celles des deux grandes familles des structures semi-actives et des structures actives.

Une structure semi-active injecte un courant de polarisation dans les diodes P.I.N. au moyen d'un circuit extérieur. La valeur du courant de polarisation étant prédéterminée selon l'émission à émettre, le limiteur de structure semi-active assure une bonne limitation pour la menace interne correspondant à l'émission du radar, car la valeur du courant à injecter est connue pour chaque type d'émission d'un radar donné et l'injection du courant de polarisation peut être synchronisée avec les signaux émis, mais il ne permet pas d'assurer une limitation adéquate pour une menace dont le niveau n'est pas connu d'avance. Le limiteur semi-actif ne permet pas la protection du récepteur contre des menaces externes dont le niveau et le moment d'apparition sont en général imprévisibles, il ne permet notamment pas de protéger le récepteur lors d'un brouillage ennemi.

Une structure active génère elle-même son propre courant de polarisation des diodes P.I.N. à l'aide d'un circuit coupleur-détecteur répondant à la puissance incidente à son entrée. Une telle structure assure une protection pour des menaces inconnues, mais sa tenue en puissance est faible.

Les limiteurs de l'art antérieur comportent des diodes en boîtier conduisant à des difficultés d'adaptation à bas niveau générant des pertes dans la plage de puissances faibles où un limiteur idéal serait transparent. Ces pertes d'insertion bas niveau lors de la réception d'un signal faible correspondant à l'écho d'une cible sont particulièrement pénalisantes pour les performances du radar. De plus, le coût unitaire d'une diode en boîtier est élevé et avec l'avènement récent des nouveaux types d'antennes actives et semi-actives, un radar comporte en général plusieurs dizaines, voir plusieurs centaines de limiteurs.

Le problème consiste à réaliser un limiteur hyperfréquence efficace notamment vis à vis des menaces externes inconnues, présentant un faible encombrement, de faibles pertes d'insertion à bas niveau et un coût unitaire beaucoup plus faible que celui des limiteurs de l'art antérieur.

L'invention propose un limiteur de puissance hyperfréquence comportant une ligne principale avec une entrée pour recevoir une puissance incidente et une sortie, la ligne principale étant couplée sur un premier tronçon d'adaptation à un réseau détecteur, le réseau détectant la puissance incidente en entrée et générant un courant, le courant étant transmis à un second tronçon d'adaptation de la ligne principale par l'intermédiaire d'un circuit de polarisation, le courant polarisant au moins une première diode P.I.N. située entre les premier et second tronçons d'adaptation de la ligne principale et désadaptée de la ligne de propagation en entrée du limiteur.

Le limiteur de l'invention génère un courant de polarisation continu issu de la transformation d'une partie de l'énergie incidente au moyen d'un réseau coupleur-détecteur et il injecte ce courant dans un étage d'une ou plusieurs diodes ne fonctionnant pas sous l'impédance caractéristique de la ligne de propagation sur laquelle le limiteur est inséré.

L'invention détecte une puissance incidente élevée et génère un courant de polarisation dont la valeur dépend du niveau de cette puissance incidente par l'intermédiaire du circuit de couplage.

L'invention présente l'avantage d'assurer une limitation pour des puissances dont la valeur est inconnue à priori du radar, la limitation est notamment assurée lors d'un brouillage.

La ou les diodes situées entre le premier et le second tronçon d'adaptation de la ligne principale, dites diodes du premier étage, fonctionnent sous impédance caractéristique différente et de préférence inférieure à celle de la ligne de propagation sur laquelle est inséré le limiteur. Le limiteur selon l'invention présente une bonne tenue en puissance, supérieure à celle des limiteurs de l'art antérieur.

L'ensemble du circuit est particulièrement compact, sa surface est d'environ quelques centimètres carrés.

L'invention comporte des diodes câblées moins coûteuses que les diodes en boîtier.

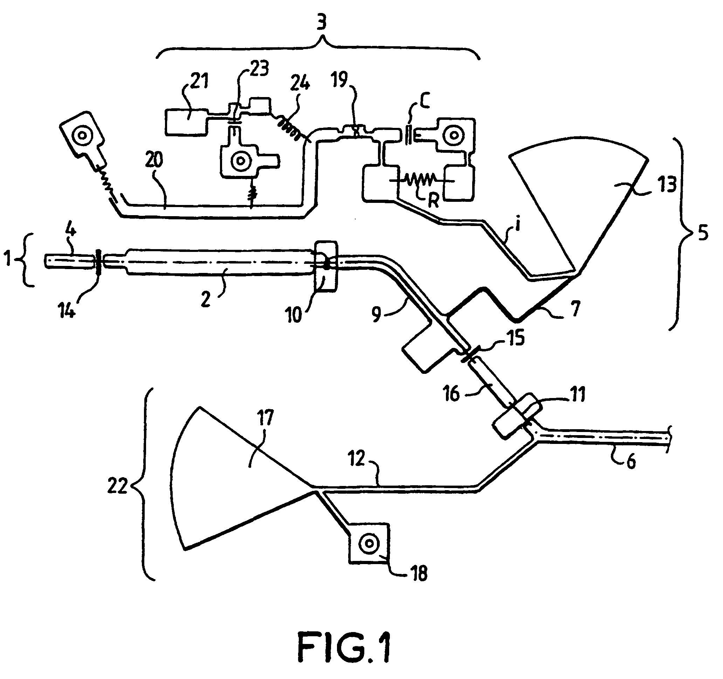

D'autres caractéristiques et avantages de l'invention apparaîtront à la lecture de la description détaillée suivante présentée à titre d'illustration non limitative et faite en référence à l'unique figure 1 annexée représentant un limiteur selon l'invention.

La figure 1 représente une réalisation de l'invention comportant une voie, ou ligne, de propagation principale 1 avec une entrée 4 et une sortie 6 entre lesquelles est assurée une limitation de la puissance. La ligne de propagation principale 1 du limiteur comporte un premier étage de limitation avec au moins une diode P.I.N. 10. La diode P.I.N. 10 est une diode limiteuse de puissance. Le premier étage comporte par exemple plusieurs diodes P.I.N., de préférence deux ou trois diodes. Le premier étage est un étage de puissance, en fonctionnement il assure par exemple une division par cent de la puissance reçue. La présence de plusieurs diodes 10 permet d'assurer une meilleure tenue en puissance, la puissance dissipée est répartie sur les diodes 10. La ou les diodes P.I.N. 10 ont de préférence une zone I importante, leur capacité de jonction est élevée. La ou les diodes P.I.N. 10 sont de préférence des diodes brasées à haute température, cela présente l'avantage de limiter leur échauffement. Les diodes P.I.N. 10 sont de préférence reportées, par exemple par brasage ou par soudure eutectique, sur un refroidisseur, non représenté sur la figure 1. Le refroidisseur est par exemple en cuivre ou de préférence en diamant synthétique, il permet de réduire l'échauffement des diodes.

Les diodes 10 du premier étage de puissance sont connectées à la ligne de propagation hyperfréquence par des fils de préférence en or.

La voie principale comporte un premier tronçon d'adaptation 2 situé entre l'entrée 4 et la diode, ou les diodes 10 du premier étage.

Le premier tronçon d'adaptation 2 est un moyen de désadaptation des diodes 10 du premier étage par rapport à la ligne de propagation, généralement à 50 ohms, en entrée 4 du limiteur. Un second tronçon d'adaptation 9 de la ligne principale du limiteur est situé entre la ou les diodes 10 du premier étage et la sortie 6 du limiteur. Le second tronçon d'adaptation 9 assure, du côté de la sortie 6 du limiteur, la réadaptation de la voie principale à la ligne de propagation sur laquelle est inséré le limiteur selon l'invention. Le second tronçon d'adaptation 9 assure à sa sortie, du côté de la sortie 6 du limiteur, une réadaptation de la ligne principale 1 à l'impédance de la ligne de propagation en entrée 4 du limiteur. La ou les diodes 10 du premier étage de limitation sont découplées au sens hyperfréquence de la ligne de propagation.

Les premier et second tronçons d'adaptation fonctionnent sous impédance caractéristique différente de celle de la ligne de propagation. L'impédance caractéristique de ces tronçons est de préférence strictement inférieure à celle de la ligne de propagation. Ils permettent à la diode, ou aux diodes, 10 du premier étage de travailler sous une impédance caractéristique plus faible que celle de la ligne de propagation. La puissance dissipée sur les diodes 10 du premier étage est inférieure à celle qui aurait été dissipée sous un fonctionnement sans désadaptation de la ligne de propagation, par exemple 50 ohms. La désadaptation sous impédance caractéristique inférieure permet de limiter l'échauffement des diodes.

Les premier et second tronçons d'adaptation peuvent être des transformateurs d'impédance avec des constantes localisées sous forme de capacités et de selfs. De préférence ces tronçons comportent des constantes réparties. Le premier tronçon d'adaptation 2 présente de préférence une longueur d'un quart de la longueur d'onde correspondant à la fréquence moyenne de la bande de fonctionnement du limiteur.

Le premier tronçon d'adaptation 2, décrit ci-dessus comme un moyen de désadaptation de la ligne de propagation, est en outre couplé à un réseau 3 de détection de la puissance reçue à l'entrée.

Une partie de la puissance reçue à l'entrée 4 du limiteur est transmise par couplage hyperfréquence au réseau 3 de détection au moyen d'un coupleur 20 de ce réseau 3. Le coupleur 20 présente une haute directivité et un couplage de l'énergie réfléchie qui est plat dans la bande de fréquence. La longueur du coupleur 20 est de préférence égale au quart d'onde.

Le premier tronçon d'adaptation 2 permet à la fois la désadaptation et le couplage hyperfréquence. La technologie des constantes réparties permet de réaliser ces deux fonctions dans la longueur du couplage. Dans l'exemple de réalisation de l'invention représentée sur la figure 1, le limiteur assure une limitation en bande S, soit de 2,7 gigahertz à 3,1 gigahertz. Pour un fonctionnement dans une autre bande de fréquences, les dimensions des circuits du limiteur sont modifiées. Le premier tronçon d'adaptation 2 est de préférence réalisé en technologie répartie dite à micro-ruban, dite encore microstrip dans la littérature anglo-saxonne. Il présente l'avantage d'être peu coûteux.

Le couplage hyperfréquence s'effectue lorsque la puissance incidente à l'entrée 4 du limiteur est suffisante pour faire entrer en conduction la ou les diodes P.I.N. 10 du premier étage. Les impédances de fermeture, par exemple cinquante ohms et cent ohms, du coupleur 20 permettent d'obtenir un couplage de l'énergie réfléchie constant dans la bande de fréquence de fonctionnement du limiteur, par exemple dans la bande S, et ceci quel que soit le niveau de conduction des diodes 10.

L'énergie couplée est proportionnelle à l'énergie réfléchie par les diodes 10 du premier étage de limitation.

Le réseau 3 de détection comporte, en aval du coupleur 20, un détecteur avec une, ou de préférence, plusieurs diodes 19 de type SCHOTTKY, de préférence MEDIUM BARRIER, ce type de diodes présentant de bonnes caractéristiques de redressement pour générer un courant élevé. Le détecteur comporte également un circuit parallèle R, C. L'énergie couplée par le coupleur 20 du réseau 3 de détection est transformée en un courant continu par le détecteur. La présence de plusieurs, par exemple deux, diodes SCHOTTKY 19 permet au détecteur de tenir une puissance plus élevée qu'avec une seule diode 19, ainsi avec l'effet du couplage la puissance incidente supportée en entrée du limiteur est plus élevée. Les diodes SCHOTTKY permettent au détecteur de présenter une dynamique importante compatible de la dynamique de la puissance d'entrée du limiteur, au coefficient de couplage près.

L'espacement entre le tronçon d'adaptation 2 et le coupleur 20 fournit une valeur de couplage permettant au détecteur de recevoir une puissance inférieure à la limite de tenue en puissance des diodes de type SCHOTTKY 19, et cependant suffisante pour faire conduire ces diodes 19 avant l'échauffement au-delà d'une température de dégradation, par exemple 150 degrés, des diodes P.I.N. 10 du premier étage de limitation.

Ce réseau 3 de détection réalise en plus une estimation de la puissance incidente reçue par le limiteur, il permet, en délivrant une tension continue sur le point 21 aux bornes d'un circuit LC, comportant une capacité 23 et une inductance ou self 24, de fournir une information de tension qui est au couplage près une fonction de la puissance incidente sur le limiteur. Dans une variante de réalisation de l'invention, la délivrance de cette tension continue est surveillée, elle présente alors l'avantage de permettre une détection de panne de l'émetteur.

Le réseau 3 de détection assure la production d'un courant i de polarisation de la diode, ou des diodes 10 du premier étage de la voie principale. Le courant i n'est pas injecté directement sur l'ensemble de diodes du premier étage de limitation, il est injecté dans le second tronçon d'adaptation 9 de la ligne principale. L'injection du courant de polarisation sur la ligne principale s'effectue au moyen d'un circuit de polarisation 5 comportant de préférence une ligne quart d'onde 7 et un premier papillon 13, également appelé stub radial, réalisé en technologie microstrip. Le circuit de polarisation 5 permet d'assurer une injection de courant i sans perturber la ligne principale.

Une première capacité 14 est située en entrée du premier tronçon d'adaptation 2, c'est-à-dire du côté de l'entrée 4 du limiteur. Une seconde capacité 15 est située en sortie du second tronçon d'adaptation 9, du côté de la sortie 6 du limiteur. Ces deux capacités permettent d'isoler la partie de la voie principale comportant le premier tronçon d'adaptation 2, la ou les diodes 10 du premier étage et le second tronçon d'adaptation 9. Ces capacités permettent au courant i injecté sur le second tronçon d'adaptation de polariser les diodes 10 du premier étage de limitation. La polarisation des diodes du premier étage de limitation leur permet de présenter une faible résistance et une puissance dissipée réduite. La polarisation permet aux diodes du premier étage de supporter une puissance incidente beaucoup plus élevée qu'en l'absence de polarisation.

Les deux capacités 14 et 15 ont de préférence une valeur de cinquante picofarads. Les deux capacités 14 et 15 sont de préférence des capacités monocouche. Elles présentent de très faibles pertes d'insertion et présentent l'avantage de ne pas perturber le fonctionnement hyper du limiteur à bas niveau et notamment lors de la réception de l'écho du signal radar précédemment émis.

Le couplage, le réseau de détection et le circuit de polarisation présentent l'avantage de fournir un courant i de polarisation dépendant de la puissance effectivement reçue par le limiteur à son entrée. Le limiteur selon l'invention est un limiteur actif qui présente l'avantage de permettre une protection efficace contre des menaces dont la puissance est inconnue.

Le limiteur selon l'invention comporte un second étage de limitation avec un ou plusieurs diodes P.I.N. 11, il est situé sur la voie principale 1 entre le second tronçon d'adaptation 9 et la sortie 6 du limiteur. La ou les diodes 11 du second étage sont placées entre la seconde capacité 15 et la sortie 6 du limiteur. La composante continue de la diode ou des diodes 11 du second étage de limitation est refermée sur la voie principale 1 au moyen d'un circuit de fermeture 22. Le circuit de fermeture est composé de préférence d'un second papillon 17, dit stub radial, d'un trou métallisé 18 et d'un second quart d'onde 12 situé entre le papillon 17 et la sortie 6 de la voie principale 1. Le circuit de fermeture 22 est facile à réaliser en technologie répartie.

La ou les diodes 11 du second étage de limitation a une capacité de jonction inférieure à celle des diodes 10 du premier étage de limitation. La diode 11 permet d'assurer une limitation complétant celle du premier étage, lequel présente un seuil de puissance de conduction assez élevé qui est dû à la capacité de jonction élevée des diodes 10 du premier étage.

La diode 11 du second étage est distante des diodes 10 du premier étage de limitation. Une ligne de complément 16 située entre le second tronçon d'adaptation 9 et la diode 11 du second étage de limitation assure une séparation entre les diodes 10, 11 des premier et second étages d'un quart de longueur d'onde de la fréquence centrale de la bande de fonctionnement du limiteur. Cette ligne de complément 16 permet de garantir l'atténuation maximale entre la puissance incidente à l'entrée 4 du limiteur et la puissance à la sortie 6 du limiteur. Le niveau de sortie du limiteur est par exemple inférieur à 20 dBm.

De préférence le second tronçon d'adaptation 9 présente une longueur d'environ un quart de longueur d'onde. La ligne de complément 16 correspondant à un petit ajustement de la distance entre les diodes du premier et du second étage. Elle facilite l'adaptation bas niveau en réduisant notamment les pertes d'insertion.

Le réseau 3 de détection présente une résistance faible. Il permet d'assurer un temps de recouvrement inverse réduit du limiteur, inférieur à 5 microsecondes, pendant lequel les porteurs des zones I des diodes 10 du premier étage se vident, la diode 11 du second étage se vidant toujours plus rapidement car sa capacité de jonction est moindre et son circuit de fermeture 22 est directement relié à la masse par le trou métallisé 18. Ce temps de recouvrement inverse réduit permet au radar de présenter de bonnes performances de détection des échos proches après la limitation nécessaire pendant l'émission du signal radar.

Le limiteur selon l'invention peut tenir plusieurs centaines de watts, au moins un kilowatt, pour des largeurs d'impulsions jusqu'à deux cents microsecondes à son entrée 4 sans dépasser une température maximale de jonction de 150 degrés des diodes 10 du premier étage. A sa sortie 6, il fournit au maximum une centaine de milliwatts. Il permet une tenue en puissance élevée associée à des pertes d'insertion faibles dans un encombrement réduit et avec un coût faible. Il est utilisable dans les modules d'émission-réception des radars état solide.

## Revendications

1. Limiteur de puissance hyperfréquence, **caractérisé en ce qu'**il comporte une ligne principale (1) avec une entrée (4) pour recevoir une puissance incidente et une sortie (6), la ligne principale comportant :
- un premier tronçon de d'adaptation (2) situé entre l'entrée (4) et au moins une première diode P.I.N. (10), désadaptant la diode (10) par rapport à la ligne de propagation en entrée (4) ;
- un deuxième tronçon d'adaptation (9) situé entre la diode (10) et la sortie (6), réadaptant la ligne principale (1) à l'impédance de ligne en entrée (4) ;
les premier et second tronçons (2, 9) fonctionnant sous impédance caractéristique strictement inférieure à celle de la ligne de propagation en entrée (4) du limiteur, la ligne principale étant couplée sur le premier tronçon d'adaptation (2) à un réseau détecteur (3), le réseau détectant la puissance incidente en entrée et générant un courant (i), le courant (i) étant transmis au second tronçon d'adaptation (9) de la ligne principale par l'intermédiaire d'un circuit de polarisation (5), le courant (i) polarisant la diode (10).

2. Limiteur de puissance hyperfréquence selon la revendication 1, **caractérisé en ce que** le premier tronçon d'adaptation (2) présente une longueur d'un quart de longueur d'onde de la fréquence moyenne de la bande de fréquence du limiteur.

3. Limiteur selon l'une des revendications précédentes, **caractérisé en ce que** le circuit de polarisation (5) comporte un premier quart-d'onde (7) et un premier papillon (13).

4. Limiteur selon l'une des précédentes revendications, **caractérisé en ce que** la ligne principale (1) comporte au moins une seconde diode P.I.N. (11), située entre le second tronçon d'adaptation (9) et la sortie (6) du limiteur, la composante continue de la seconde diode P.I.N. (11) étant refermée sur la ligne principale (1) au moyen d'un circuit de fermeture (22).

5. Limiteur selon l'une des précédentes revendications, **caractérisé en ce qu'**il comporte une première capacité (14) à l'entrée du premier tronçon d'adaptation (2) et une seconde capacité (15) en sortie du second tronçon d'adaptation (9), les première et seconde capacités étant des capacités monocouche avec une très faible perte d'insertion.

6. Limiteur selon l'une des revendications 4 et 5, **caractérisé en ce que** la ou les secondes diodes (11) de la ligne principale (1) a ou ont une capacité de jonction inférieure à celle de la, ou des premières diodes (10) de ladite ligne principale (1).

7. Limiteur selon l'une des revendications 4, 5 et 6, **caractérisé en ce que** le second tronçon d'adaptation (9) assure à sa sortie une réadaptation de la ligne principale (1) à l'impédance de la ligne de propagation en entrée (4) du limiteur.

8. Limiteur selon la revendication 7 **caractérisé en ce qu'**il comporte une ligne de complément (16) située entre le second tronçon d'adaptation (9) et la seconde diode (11) de la ligne principale (1) telle que l'ensemble du second tronçon (9) et de la ligne de complément (16) sépare les premières (10) et secondes (11) diodes d'un quart de longueur d'onde de la fréquence centrale de la bande pour garantir l'atténuation maximale entre la puissance incidente à l'entrée (4) du limiteur et la puissance à la sortie (6) du limiteur.

9. Limiteur selon la revendication 8, **caractérisé en ce que** le second tronçon d'adaptation (9) présente une longueur d'environ un quart de longueur d'onde.

10. Limiteur selon l'une des revendications précédentes, **caractérisé en ce que** le réseau détecteur (3) comporte au moins une diode (19) de type SCHOTTKY MEDIUM BARRIER.

11. Limiteur selon la revendication 4, **caractérisé en ce que** le circuit de fermeture (22) est comporte un second papillon (17), un trou métallisé (18) et un second quart d'onde (12).

12. Limiteur selon l'une des revendications précédentes, **caractérisé en ce que** le réseau détecteur (3) comporte un circuit LC avec une capacité (23) et une inductance (24) pour fournir une information de tension proportionnelle à la puissance incidente reçue sur l'entrée (4).

13. Limiteur selon l'une des revendications précédentes, **caractérisé en ce qu'**il comporte un refroidisseur en cuivre ou en diamant synthétique sur lequel est reporté la ou les diodes P.I.N. (10).

## Patentansprüche

1. Höchstfrequenz-Leistungsbegrenzer, **dadurch gekennzeichnet, dass** er eine Hauptleitung (1) mit einem Eingang (4) zum Empfang einer einfallenden Leistung und mit einem Ausgang (6) aufweist, wobei die Hauptleitung aufweist:
- einen ersten Anpassungsabschnitt (2), der sich zwischen dem Eingang (4) und mindestens einer ersten PIN-Diode (10) befindet und die Diode (10) bezüglich der Ausbreitungsleitung am Eingang (4) fehlanpasst;
- einen zweiten Anpassungsabschnitt (9), der sich zwischen der Diode (10) und dem Ausgang (6) befindet und die Hauptleitung (1) wieder an die Leitungsimpedanz am Eingang (4) anpasst;
wobei der erste und der zweite Abschnitt (2, 9) mit einer charakteristischen Impedanz arbeiten, die strikt geringer ist als diejenige der Ausbreitungsleitung am Eingang (4) des Begrenzers,
wobei die Hauptleitung im ersten Anpassungsabschnitt (2) an ein Detektornetz (3) gekoppelt ist, wobei das Netz die einfallende Leistung am Eingang erfasst und einen Strom (i) erzeugt, wobei der Strom (i) an den zweiten Anpassungsabschnitt (9) der Hauptleitung über eine Vorspannungsschaltung (5) übertragen wird, wobei der Strom (i) die Diode (10) vorspannt.

2. Höchstfrequenz-Leistungsbegrenzer nach Anspruch 1, **dadurch gekennzeichnet, dass** der erste Anpassungsabschnitt (2) eine Länge einer Viertelwellenlänge der mittleren Frequenz des Frequenzbands des Begrenzers aufweist.

3. Begrenzer nach einem der vorhergehenden Ansprüche, **dadurch gekennzeichnet, dass** die Vorspannungsschaltung (5) eine erste Viertelwellenlängenleitung (7) und eine erste Blindleitung (13) aufweist.

4. Begrenzer nach einem der vorhergehenden Ansprüche, **dadurch gekennzeichnet, dass** die Hauptleitung (1) mindestens eine zweite PIN-Diode (11) aufweist, die sich zwischen dem zweiten Anpassungsabschnitt (9) und dem Ausgang (6) des Begrenzers befindet, wobei der Gleichstromanteil der zweiten PIN-Diode (11) mittels einer Schließschaltung (22) wieder auf die Hauptleitung (1) rückgeschlossen ist.

5. Begrenzer nach einem der vorhergehenden Ansprüche, **dadurch gekennzeichnet, dass** er einen ersten Kondensator (14) am Eingang des ersten Anpassungsabschnitts (2) und einen zweiten Kondensator (15) am Ausgang des zweiten Anpassungsabschnitts (9) aufweist, wobei der erste und der zweite Kondensator Einschicht-Kondensatoren mit einem sehr geringen Dämpfungsverlust sind.

6. Begrenzer nach einem der Ansprüche 4 und 5, **dadurch gekennzeichnet, dass** die zweite(n) Diode(n) (11) der Hauptleitung (1) eine Sperrschichtkapazität hat (oder haben), die geringer ist als diejenige der ersten Diode(n) (10) der Hauptleitung (1).

7. Begrenzer nach einem der Ansprüche 4, 5 und 6, **dadurch gekennzeichnet, dass** der zweite Anpassungsabschnitt (9) an seinem Ausgang eine Wiederanpassung der Hauptleitung (1) an die Impedanz der Ausbreitungsleitung am Eingang (4) des Begrenzers gewährleistet.

8. Begrenzer nach Anspruch 7, **dadurch gekennzeichnet, dass** er eine Zusatzleitung (16) aufweist, die zwischen dem zweiten Anpassungsabschnitt (9) und der zweiten Diode (11) der Hauptleitung (1) angeordnet ist, derart, dass die Einheit aus zweitem Abschnitt (9) und Zusatzleitung (16) die ersten (10) und zweiten Dioden (11) um eine Viertelwellenlänge von der zentralen Frequenz des Bands trennt, um die maximale Dämpfung zwischen der einfallenden Leistung am Eingang (4) des Begrenzers und der Leistung am Ausgang (6) des Begrenzers zu garantieren.

9. Begrenzer nach Anspruch 8, **dadurch gekennzeichnet, dass** der zweite Anpassungsabschnitt (9) eine Länge von etwa einer Viertelwellenlänge aufweist.

10. Begrenzer nach einem der vorhergehenden Ansprüche, **dadurch gekennzeichnet, dass** das Detektornetz (3) mindestens eine Diode (19) vom Typ SCHOTTKY MEDIUM BARRIER aufweist.

11. Begrenzer nach Anspruch 4, **dadurch gekennzeichnet, dass** die Schließschaltung (22) eine zweite Blindleitung (17), ein durchmetallisiertes Loch (18) und eine zweite Viertelwellenleitung (12) aufweist.

12. Begrenzer nach einem der vorhergehenden Ansprüche, **dadurch gekennzeichnet, dass** das Detektornetz (3) eine LC-Schaltung mit einem Kondensator (23) und einer Induktanz (24) aufweist, um eine Spannungsinformation proportional zur am Eingang (4) empfangenen einfallenden Leistung zu liefern.

13. Begrenzer nach einem der vorhergehenden Ansprüche, **dadurch gekennzeichnet, dass** er einen Kühler aus Kupfer oder Synthetikdiamant enthält, auf den die PIN-Diode (n) (10) verschoben ist (sind).

## Claims

1. Microwave power limiter, **characterized in that** it comprises a main line (1) with an input (4) for receiving an incident power and an output (6), the main line comprising:
- a first matching section (2) located between the input (4) and at least a first PIN diode (10), mismatching the diode (10) relative to the propagation line as input (4); and
- a second matching section (9) located between the diode (10) and the output (6), rematching the main line (1) to the line impedance of the input (4),
the first and second sections (2, 9) operating with a characteristic impedance of strictly less than that of the propagation line as input (4) of the limiter, the main line being coupled on the first matching section (2) to a detector network (3), the detector network detecting the incident power at the input and generating a current (i), the current (i) being transmitted to the second matching section (9) of the main line via a bias circuit (5), the current (i) biasing the diode (10).

2. Microwave power limiter according to Claim 1, **characterized in that** the first matching section (2) has a length of one quarter of the wavelength corresponding to the mean frequency of the frequency band of the limiter.

3. Limiter according to one of the preceding claims, **characterized in that** the bias circuit (5) includes a first quarter-wave line (7) and a first butterfly (13).

4. Limiter according to one of the preceding claims, **characterized in that** the main line (1) includes at least one second PIN diode (11), located between the second matching section (9) and the output (6) of the limiter, the DC component of the second PIN diode (11) terminating on the main line (1) by means of a termination circuit (22).

5. Limiter according to one of the preceding claims, **characterized in that** it includes a first capacitor (14) at the input of the first matching section (2) and a second capacitor (15) at the output of the second matching section (9), the first and second capacitors being monolayer capacitors of very low insertion loss.

6. Limiter according to either of Claims 4 and 5, **characterized in that** the one or more second diodes (11) of the main line (1) has or have a junction capacitance smaller than that of the one or more first diodes (10) of said main line (1).

7. Limiter according to one of Claims 4, 5 and 6, **characterized in that** the second matching section (9) ensures, at its output, rematching of the main line (1) to the impedance of the propagation line as input (4) of the limiter.

8. Limiter according to Claim 7, **characterized in that** it includes a supplementary line (16) located between the second matching section (9) and the second diode (11) of the main line (1), such that the assembly comprising the second section (9) and the supplementary line (16) separates the first (10) and second (11) diodes by a quarter of the wavelength corresponding to the central frequency of the band, in order to guarantee maximum attenuation between the incident power at the input (4) of the limiter and the power at the output (6) of the limiter.

9. Limiter according to Claim 8, **characterized in that** the second matching section (9) has a length of approximately one quarter of the wavelength.

10. Limiter according to one of the preceding claims, **characterized in that** the detector network (3) includes at least one diode (19) of the Schottky medium barrier type.

11. Limiter according to Claim 4, **characterized in that** the termination circuit (22) is or includes a second butterfly (17), a metallized hole (18) and a second quarter-wave line (12).

12. Limiter according to one of the preceding claims, **characterized in that** the detector network (3) includes an LC circuit with a capacitor (23) and an inductor (24) in order to deliver a voltage datum proportional to the incident power received on the input (4).

13. Limiter according to one of the preceding claims, **characterized in that** it includes a cooler, made of copper or synthetic diamond, on which the one or more PIN diodes (10) are carried.
